(19) Europäisches Patentamt

European Patent Office

Office européen des brevets

(11) **EP 1 182 510 B1**

(12) **EUROPEAN PATENT SPECIFICATION**

(45) Date of publication and mention
of the grant of the patent:
**12.04.2006 Bulletin 2006/15**

(51) Int Cl.:
***G03F 7/20*** (2006.01)

(21) Application number: **01307163.4**

(22) Date of filing: **23.08.2001**

(54) **Lithographic projection apparatus**

Lithographischer Projektionsapparat

Appareil de projection lithographique

(84) Designated Contracting States:
**DE FR GB IT NL**

(30) Priority: **25.08.2000 EP 00202960**
**04.09.2000 EP 00307594**
**22.03.2001 EP 01302647**
**21.05.2001 EP 01304489**

(43) Date of publication of application:
**27.02.2002 Bulletin 2002/09**

(73) Proprietor: **ASML Netherlands B.V.**
**5504 DR Veldhoven (NL)**

(72) Inventors:
• **Moors, Johannes Hubertus Josephina**
**5503 LA Helmond (NL)**
• **Banine, Vadim Yevgenyevich**
**5704 NK Helmond (NL)**
• **Leenders, Martinus Hendrikus Antonius**
**3039 ER Rotterdam (NL)**
• **Werij, Henri Gerard Cato**
**3054 CV Rotterdam (NL)**
• **Visser, Hugo Matthieu**
**3512 VK Utrecht (NL)**
• **Heerens, Gerrit-Jan**
**2871 ZH Schoonhoven (NL)**
• **Ham, Erik Leonardus**
**3011 DK Rotterdam (NL)**
• **Meiling, Hans**
**3722 BG Bilthoven (NL)**
• **Loopstra, Erok Roelof**
**5591 BA Heeze (NL)**
• **Donders, Sjoerd Nicolaas Lambertus**
**5211 HN 's-Hertogenbosch (NL)**

(74) Representative: **Leeming, John Gerard**
**J.A. Kemp & Co.,**
**14 South Square,**
**Gray's Inn**
**London WC1R 5LX (GB)**

(56) References cited:
**EP-A- 0 858 249       EP-A- 0 987 601**
**US-A- 4 695 732       US-A- 5 469 963**
**US-A- 5 567 949       US-A- 5 838 006**

**Description**

The present invention relates to particle shields for preventing contaminant particles from reaching a mask. More particularly, the invention relates to the application of such particle shields in mask handling apparatus, mask storage boxes and/or in lithographic projection apparatus comprising:

> a radiation system for supplying a projection beam of radiation;
> a support structure for supporting patterning means, the patterning means serving to pattern the projection beam according to a desired pattern;
> a substrate table for holding a substrate; and
> a projection system for projecting the patterned beam onto a target portion of the substrate.

The term "patterning means" as here employed should be broadly interpreted as referring to means which can be used to endow an incoming radiation beam with a patterned cross section, corresponding to a pattern which is to be created in a target portion of the substrate. The term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase shift, and attenuated phase shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix addressable surface. The required matrix addressing can be performed using suitable electronic means. More information on such mirror arrays can be gleaned, for example, from United States Patents US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as here above set forth.

Lithographic projection apparatus can be used, for example, in the manufacture of integrated circuits (ICs). In such a case, the patterning means may generate a circuit pattern corresponding to an individual layer of the IC. This pattern can be imaged onto a target portion (*e.g.* comprising one or more dies) on a substrate (silicon wafer) which has been coated with a layer of radiation sensitive material (resist). In general, a single wafer will contain a whole network of adjacent target portions, which are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go. Such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or antiparallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate which is at least partially covered by a layer of radiation sensitive material (resist). Prior to this imaging step, the substrate may undergo various procedures, such as priming, resist coating and a soft bake. After exposure, the substrate may be subjected to other procedures, such as a post exposure bake (PEB), development, a hard bake and measurement/inspection of the imaged features. This array of procedures is used as a basis to pattern an individual layer of a device, e.g. an IC. Such a patterned layer may then undergo various processes such as etching, ion implantation (doping), metallization, oxidation, chemo-mechanical polishing, etc., all intended to finish off an individual layer. If several layers are required, then the whole procedure or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book *Microchip Fabrication: A Practical Guide to Semiconductor Processing,* Third Edition, by Peter van Zant, McGraw Hill Publishing Co., 1997, ISBN 0-07-067250-4.

In a lithographic projection apparatus, it is necessary to prevent any stray particles, which may be present in the apparatus from reaching, and becoming stuck to, the mask as they will then be imaged on the substrate and can be printed in the final device. Too high a level of contamination of the mask can lead to defective devices and the masks cannot generally be cleaned, or if cleanable can only be cleaned a limited number of times. In a lithographic projection apparatus using relatively long wavelength ultraviolet radiation, particles are prevented from reaching the mask by a pellicle. A pellicle is a thin membrane transparent to the radiation used in the projection beam of the lithographic apparatus and located parallel to but spaced from the mask. Contaminant particles moving towards the mask contact and stick to the pellicle. To ensure that the particles stuck to the pellicle are not printed on the substrate, the pellicle is spaced from the mask by a distance greater than the depth of focus at mask level.

However, it is not at present possible to provide a pellicle in a lithographic projection apparatus using UV radiation of 193nm or 157nm or extreme ultraviolet radiation for the exposure beam. Almost all materials are strongly absorptive of EUV radiation and a conventional membrane pellicle would have to be no more than about 30nm thick in order not to cause unacceptable absorption of the projection beam. A membrane of this thickness would not have a sufficient lifetime in both a vacuum, during operation of the apparatus and atmospheric environment, during installation and service. Other stresses, such as optical stress and temperature variance would also likely destroy such a thin membrane very quickly.

An alternative approach to a separate pellicle membrane is to form a cap layer, again transparent to the exposure radiation, directly onto the mask. To be effective, the cap layer would need to be thicker than the depth of focus at mask level. The depth of focus at mask level is given by:

$$DOF = k_2 \cdot \frac{\lambda}{NA^2} \cdot \frac{1}{M^2} \qquad (1)$$

where $\lambda$ is the wavelength of the EUV radiation, NA the numerical aperture at wafer level, M the magnification of the projection optics and $k_2$ a constant which is typically near 1. For EUV radiation of 13.5nm, a numerical aperture of 0.25 and a magnification M of 1/5, the depth of focus at mask level is approximately $2.7\mu m$. The effect of such a layer on an EUV projection beam would be excessive. The transmission, $T$, of radiation through a material with thickness $d$ is given by:

$$T = \exp\left(-\frac{d}{a}\right) \qquad (2)$$

where $a$ is the attenuation length of the material (i.e, the length over which the intensity drops by a factor of 1/e). Even for a material which is relatively transparent to radiation at 13.5nm, the attenuation length is about $0.6\mu m$. Accordingly, a cap layer of thickness $2.7\mu m$ would absorb about 99% of all EUV radiation.

Furthermore, when shorter wavelength radiation is used for the projection beam, the sensitivity to contaminants is increased. At EUV wavelengths, a contaminant particle of only 50nm diameter can lead to a faulty image. The need to keep the mask and other optical elements clear of contaminant particles is therefore extremely great.

Yet further, the projection beam of radiation in a lithographic projection apparatus may cause electrons to be freed from any surface on which it is incident. The surfaces which the beam of radiation is incident on include mirrors in the radiation system and the projection system as well as the substrate, sensors and the patterning means. Freed electrons in turn may break the bonds in water and hydrocarbon molecules present on the surfaces, resulting in reactive contaminants that cause damage to the surface. OH, in particular seems to cause substantial damage. Furthermore, the decomposition of the molecule does not absorb the stray electrons, which can then return to the surface and cause further damage on the surface.

EP-0 858 249 A1 discloses a laser plasma x-ray source for use in a lithography apparatus which uses a negatively charged electrode to collect ions emitted from the plasma.

It is an object of the present invention to provide a particle shield which is effective in mask handling apparatus and a lithographic projection apparatus using radiation of wavelength less than 200nm, and especially extreme ultraviolet radiation, to prevent particles reaching the mask whilst avoiding unacceptable attenuation of the projection beam.

According to the present invention there is provided a lithographic projection apparatus according to claim 1.

The particle shield means may generate a substantially uniform (purely) electric field, generally transverse to the direction of particles approaching the shielded object, so as to exert a force on all charged particles which will deflect them away from the object to be shielded. Although such a uniform electric field may not deflect neutral particles, the radiation of the projection beam in a lithographic apparatus, which is the principle source of energy for airborne particles in a lithographic apparatus, is strongly ionizing so that any particles likely to cause problems will almost certainly be charged and will generally have a charge many times the charge of an electron. A substantially uniform electric field can conveniently be generated using a capacitor like arrangement of conductive plates.

The particle shield may also, in addition, generate a non-uniform electric field so as to induce a dipole moment in neutral particles and then attract those particles in addition to charged particles. A non-uniform electric field can conveniently be generated using a charged elongate member.

The particle shield may further generate an alternating, or other time varying field, instead of or in addition to the uniform or non-uniform static fields.

The particle shield may also, in addition to the uniform or non-uniform electric fields, generate a transverse radiation beam (i.e. oscillating electric and magnetic fields), or optical breeze, which will transfer transverse momentum to particles entering the transverse beam and absorbing photons from it. The radiation wavelength can be chosen so as to be absorbed by all expected particles but not expose the resist should any stray radiation reach substrate level.

The particle shield can also further comprise a radiation source directing ionizing radiation, e.g. suitably short wavelength electromagnetic radiation or an electron beam, across the front of the object to be shielded. With such an arrangement the object to be shielded can be charged positively, to repel positively charged ions, compared to its surroundings, and relatively negative collection plates can be provided to attract positively charged ions. This arrangement ensures protection of the object to be shielded even when the main projection beam is off.

The object to be shielded is a mask, since particles adhering to the mask are most detrimental to the quality of the projected image.

By using an electric field rather than a physical barrier, the particle shield of the present invention performs its function without any attenuation of the projection beam.

The present invention also provides a device manufacturing method according to claim 16.

In a further aspect the invention provides a transportable mask storage box according to claim 17.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, unless the context otherwise requires the terms "radiation" and "beam" are used to encompass all types of electromagnetic radiation, including ultraviolet radiation (*e.g.* with a wavelength of 365nm, 248nm, 193nm, 157nm or 126nm) and EUV (extreme ultraviolet radiation, *e.g.* having a wavelength in the range 5nm to 20nm).

The present invention and its attendant advantages will be described below with reference to exemplary embodiments and the accompanying schematic drawings, in which:

Figure 1 depicts a lithographic projection apparatus according to a first embodiment of the invention;

Figure 2 is a diagram of a particle shield in the first embodiment of the present invention;

Figure 3 is a diagram of a particle shield in a second embodiment of the present invention;

Figure 4 is a diagram showing the induced dipole moment in a neutral particle;

Figure 5 is a diagram of a particle shield in a third apparatus described for reference and not forming part of the invention;

Figure 6 is a diagram of a particle shield in a fourth apparatus described for reference and not forming part of the invention;

Figure 7 is a diagram of a particle shield in a third embodiment of the present invention;

Figure 8 is a diagram of a particle shield in a fourth embodiment of the present invention;

Figure 9 is a diagram of a particle shield according to a fifth apparatus described for reference and not forming part of the invention;

Figures 10, 11 and 12 are perspective views of three variants of the fifth apparatus described for reference and not forming part of the invention;

Figure 13 is a diagram of relevant parts of a lithographic apparatus incorporating particle shields according to a fifth embodiment of the present invention;

Figure 14 is a diagram of a particle shield in an sixth embodiment of the present invention;

Figure 15 is a diagram of a particle shield in a variant of the sixth embodiment of the present invention;

Figure 16 is a diagram of a particle trap in a seventh embodiment of the present invention;

Figure 17 is a diagram of a vacuum seal incorporating a particle shield according to a seventh apparatus described for reference and not forming part of the present invention;

Figure 18 is a partial cross-sectional view of a mask storage box according to an eigth embodiment of the invention; and

Figure 19 is a partial cross-section of an eighth apparatus described for reference and not forming part of the invention.

In the various drawings, like parts are indicated by like references.

Embodiment 1

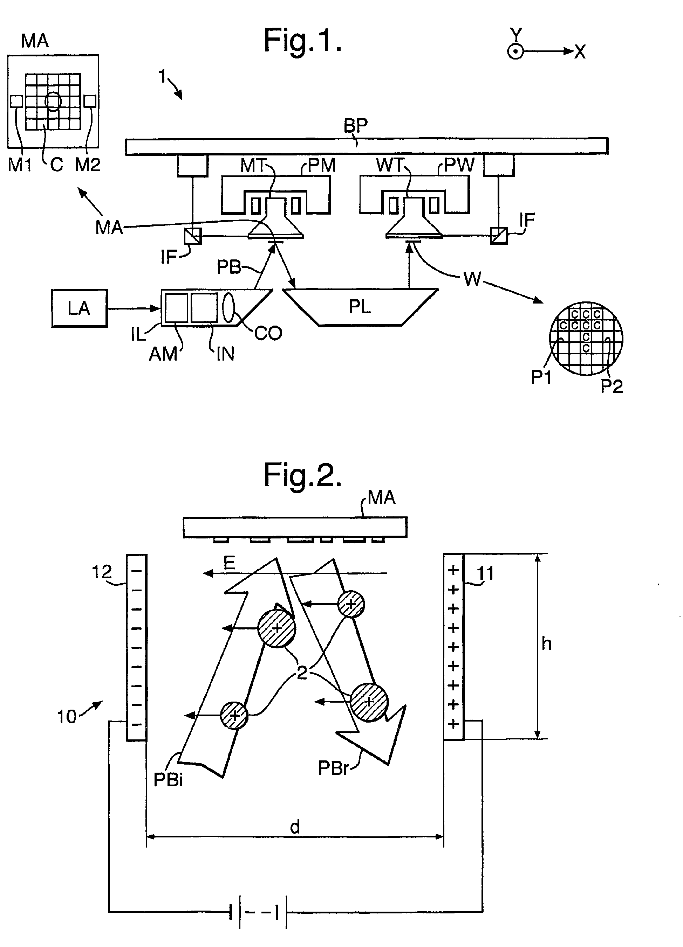

Figure 1 schematically depicts a lithographic projection apparatus according to a particular embodiment of the invention. The apparatus comprises:

a radiation system Ex, IL, for supplying a projection beam PB of radiation (e.g. EUV radiation), which in this particular case also comprises a radiation source LA;

a first object table (mask table) MT provided with a mask holder for holding a mask MA (*e.g.* a reticle), and connected to first positioning means PM for accurately positioning the mask with respect to item PL;

a second object table (substrate table) WT provided with a substrate holder for holding a substrate W (*e.g.* a resist coated silicon wafer), and connected to second positioning means PW for accurately positioning the substrate with respect to item PL;

a projection system ("lens") PL (e.g. a mirror system) for imaging an irradiated portion of the mask MA onto a target portion C (e.g. comprising one or more dies) of the substrate W.

As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a discharge or laser produced plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means PW (and interferometric measuring means IF), the substrate table WT can be moved accurately, *e.g.* so as to position different target portions C in the path of the beam PB. Similarly, the first positioning means PM can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so called "scan direction", eg. the y direction) with a speed v, so that the projection beam PB is caused to scan over a mask image. Concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure 2 shows an electrostatic particle shield 10 provided in the vicinity of mask MA. The particle shield 10 of the invention may be attached to the mask holder, mask table MT, a frame of the apparatus or any other suitable means, rather than the mask itself, as are conventional pellicles. It will be seen that the mask MA is reflective and disposed generally horizontally with the reflecting surface facing downward. The incident projection beam PBi is directed from the illumination system IL generally upwardly onto the mask MA and the reflected projection beam PBr is then reflected downwards to the projection system PL. As the operative surface of the mask faces downwards, gravity will tend to keep particles present in the apparatus away from the mask. However the powerful EUV projection beam provides energy to particles in its path which can enable them to overcome gravity. In particular, photons in the incident projection beam PBi colliding with particles will impart a generally upward momentum. Thus, contaminant particles can be driven towards the mask MA where they will cause undesirable contamination. Brownian motion of contaminant particles also yields a direction of motion towards the mask or another sensitive object. Moving parts of the apparatus can also both create contaminant particles and provide transport energy to overcome gravity.

To prevent this, the electrostatic particle shield 10 comprises two capacitor like plates 11, 12 placed perpendicular to the mask on either side of it. The plates 11, 12 are oppositely charged so as to establish an electric field E between them. Assuming that the area of the plates 11, 12 is substantially greater than their separation, $d$, the electric field, $E$, is given by:

$$E = \frac{V}{d} \tag{3}$$

where $V$ is the voltage across the capacitor. In an embodiment of the present invention, the separation, $d$, may be about 300mm, approximately twice the width of a mask, and the potential difference between plates 11, 12 may be about 10kV. This gives an electric field of 33kV/m

The force exerted on a charged particle in the electric field between capacitor plates 11, 12, is equal to the product of the charge on the particle and the electric field strength, E. In an operating lithographic apparatus using EUV exposure radiation it can be assumed that any particles entering the projection beam will become rapidly ionized. The energy of an EUV photon is 92eV compared to an ionization energy of the order of only a few eVs. A particle of 20nm diameter in a projection beam having a typical power density of 8kW/m$^2$ will be impacted by about $1.7 \times 10^5$ photons per second and will thus very likely be multiply ionized. For a singly ionized particle, the worst case, the force exerted on the particle will be about $5.3 \times 10^{-15}$ N. It can be shown that this force is sufficient to prevent such particles reaching the mask. The time, t,

$$t = \sqrt{\frac{2dm}{F}} \tag{4}$$

where $m$ is the mass of the particle and $F$ the electrical force. Table 1 below gives the transit time for various different sizes of particle, assuming a spherical particle having a density $\rho$ equal to 2,000kg/m$^3$.

| Particle Size | Time |
|---------------|--------|
| 20nm | 0.1ms |
| 100nm | 11ms |
| 500nm | 0.11s |
| 1$\mu$m | 0.35s |

In the worst case, a particle ejected from a metal part in the apparatus, e.g. following a collision, could be moving at maximum at the speed of sound in the metal, e.g. about 5,000m/s. A particle of 20nm diameter moving at this speed through the capacitor will be deflected if the height, h, of the capacitor plates 11, 12 is about 500mm and less at lower speeds. This is the case even if the particle is only minimally charged. It should also be noted that, due to their substantially higher charge to mass ratios, any ions or charged molecules would be very quickly deflected by the electrostatic particle shield 10.

In a variant of the first embodiment, an alternating voltage is provided between electrodes 11 and 12 to generate a plasma that is confined between the electrodes and serves as a barrier to contaminant particles approaching the mask MA. Neutral particles approaching the plasma will rapidly become ionized and trapped in the plasma. The plasma may be formed in a atmosphere of an inert gas, e.g. Argon, at a pressure of the order of 1 mbar. The alternating voltage may be such as to establish a field strength of about 100 to 500 V/cm and may have a frequency of about 1 to 10 MHz.

Embodiment 2

A second embodiment of the present invention, which may be the same as the first embodiment save as described below, includes an electrostatic particle shield 20 making use of a non-uniform electric field, which may prove more efficient.

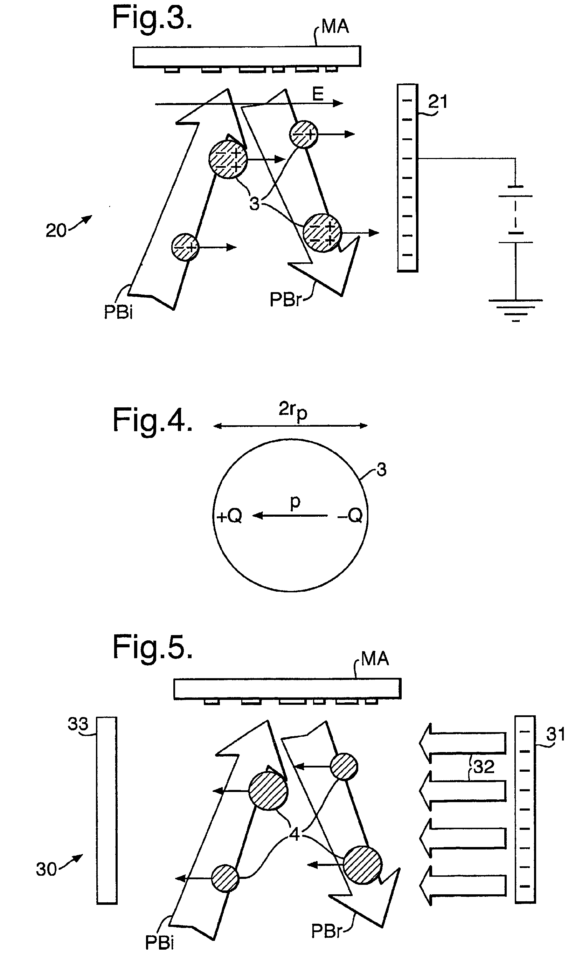

The electrostatic particle shield 20 of the second embodiment of the invention is shown in Figure 3. An elongate charged member 21 is placed perpendicular to and to one side of the mask MA, adjacent the volume traversed by the incident and reflected projection beams PBi, PBr. A single charged member, as opposed to a pair of charged plated forming a capacitor, forms a non-uniform electric field, which induces a dipole in neutral molecules and particles and then exerts a force on the dipole. A non-uniform electric field will also exert a force on polar molecules and so will capture these as well as neutral molecules or particles in which a dipole moment is induced. The force exerted on a dipole is given by:

$$\vec{F} = (\vec{p} . \vec{\nabla}) \vec{E} \tag{5}$$

where p is the induced dipole moment of the particle. The elongate charged member 21 can be approximated as a cylinder with a charge per unit length of the cylinder of $\mu$Coulomb/m. This will induce an electric field given by:

$$E(\vec{r}) = \frac{\mu}{2\pi\varepsilon_0 r} \tag{6}$$

where $\vec{r}$ is a position vector in an arbitrary coordinate system, r is the distance to the center of the cylinder, and $\varepsilon_0$ is the dielectric constant in vacuum. The electric field inside a sphere with dielectric constant $\varepsilon$ is given by:

$$E_{particle}(\vec{r}) = \frac{3}{\varepsilon + 2} E(\vec{r}), \tag{7}$$

whilst the electric field which is induced by displaced charges inside the particle is given by:

$$E_{induced}(\vec{r}) = -\frac{\varepsilon - 1}{\varepsilon + 2} E(\vec{r}). \tag{8}$$

The polarization *P* is defined as the dipole moment per unit volume and given by:

$$P = \varepsilon_0 (\varepsilon - 1) E_{particle} = \frac{\varepsilon - 1}{\varepsilon + 2} 3 \varepsilon_0 E(r), \qquad (9)$$

for a particle at a distance r from the center of the charged cylinder so that the particle having a radius $r_p$ can be replaced by a dipole with a moment, $p$, given by:

$$p = \frac{\varepsilon - 1}{\varepsilon + 2} 4 \pi \varepsilon_0 r_p^3 E(r). \qquad (10)$$

The particle can thus be regarded as charges +Q, -Q separated by twice the radius $\gamma_p$ of the particle, as shown in Figure 4. The magnitude of the charges Q is given by:

$$Q = \frac{\varepsilon - 1}{\varepsilon + 2} 2 \pi \varepsilon_0 r_p^2 E(r) = \frac{\varepsilon - 1}{\varepsilon + 2} \frac{r_p^2 \mu}{r}. \qquad (11)$$

From this, the force on the dipole can be expressed as:

$$F = QE(r - r_p) - QE(r + r_p) = \frac{Q\mu}{2 \pi \varepsilon_0 (r - r_p)} - \frac{Q\mu}{2 \pi \varepsilon_0 (r + r_p)} \qquad (12)$$

which can be approximated, when the particle radius is small compared to the distance from the elongate charge member 21, as:

$$F \cong \frac{Q\mu}{2 \pi \varepsilon_0 r} \cdot \frac{2 r_p}{r} = \frac{Q\mu r_p}{\pi \varepsilon_0 r^2} = \frac{\varepsilon - 1}{\varepsilon + 2} \cdot \frac{\mu^2 r_p^3}{\pi \varepsilon_0 r^3}. \qquad (13)$$

Because this force is dependent on the cube of the particle radius, the acceleration experienced by particles is independent of size. For a particle of density, $\varrho$, equal to 2,000kg/m$^3$ and a charge density, $\mu$, of $10^{-7}$Coulomb/m, the time to travel over a distance of about 150mm, the size of a mask, for different dielectric constants, $\varepsilon$, is given in Table 2 below:

| $\varepsilon$ | Time (s) |
|---|---|
| 2 | 224 |
| 3 | 177 |
| 5 | 158 |
| $\infty$ (metal particles) | 112 |

Although it does take a significant time for the particles to reach the charged member 21, the non-uniform field will effectively capture neutral particles in the apparatus since the non-uniform field can be arranged to extend for a distance several times the mask width in front of the mask, allowing plenty of time for the particles to be deflected.
A third apparatus is described for reference and does not form part of the invention. It may be the same as the first or second embodiments save as described below and employs an optical particle shield which creates an optical breeze to deflect contaminant particles.

The third apparatus is shown in Figure 5 and comprises radiation source 31 which emits high intensity shielding beams 32 of electromagnetic radiation parallel to the mask MA and across the space in front of it. The radiation source 31 can be any suitable source, or array of sources, with appropriate collimating and/or directing means to direct the beam across the required space whilst minimizing generation of stray light outside the desired area. A beam absorber 33 may be placed on the other side of the space in front of the mask MA to absorb the shielding radiation and prevent reflections. The photons of the shielding beams 32 carry momentum m, which will be transferred to any particle which absorbs photons from the beams 32. The wavelength of the light in the particle shield 30 is therefore chosen to be absorbed by all particles expected. The wavelength may also be chosen as one to which the resist used is not sensitive so that any stray light, which does reach the substrate, does not expose the resist.

The pressure exerted by a radiation beam of intensity $I$ per m2 is given by:

$$P_{BEAM} = \frac{I}{c}$$

$$(14)$$

where c is the velocity of light ($3 \times 10^8$m/s). The acceleration of a spherical particle with radius $r_p$ and density $\rho$ is given by:

$$a_{breeze} = \frac{3I}{4cr_p\rho}$$

$$(15)$$

which is constant with time so that the time required to travel over a distance d is given by:

$$t = \sqrt{\frac{2d}{a_{breeze}}} = \sqrt{\frac{8dcr_p\rho}{3I}}$$

$$(16)$$

The time taken for particles of various sizes to travel over a distance of 150mm, the approximate size of a mask, are given in Table 3 below, assuming a particle density, $\rho$, of 2,000kg/m$^3$ and an intensity of 8kW/m$^2$.

| Particle Size (nm) | Time (s) |
| --- | --- |
| 10 | 0.4 |
| 25 | 0.6 |
| 50 | 0.9 |
| 100 | 1.8 |

Again, if the optical particle shield 30 is arranged to extend over a substantial distance in front of the mask MA, a significant deflection can be achieved. In particular, the optical particle shield can be arranged to have a similar radiation intensity to the projection beam PB so that the deflection force exerted by the optical shield is comparable to the force exerted by the projection beam tending to lift the particles towards the mask MA.

A fourth apparatus, again described for reference and not forming part of the invention, may be the same as the first and second embodiments or third apparatus save as described below. Additional ionizing radiation is provided in front of the element to be protected which is itself charged to repel ions approaching it.

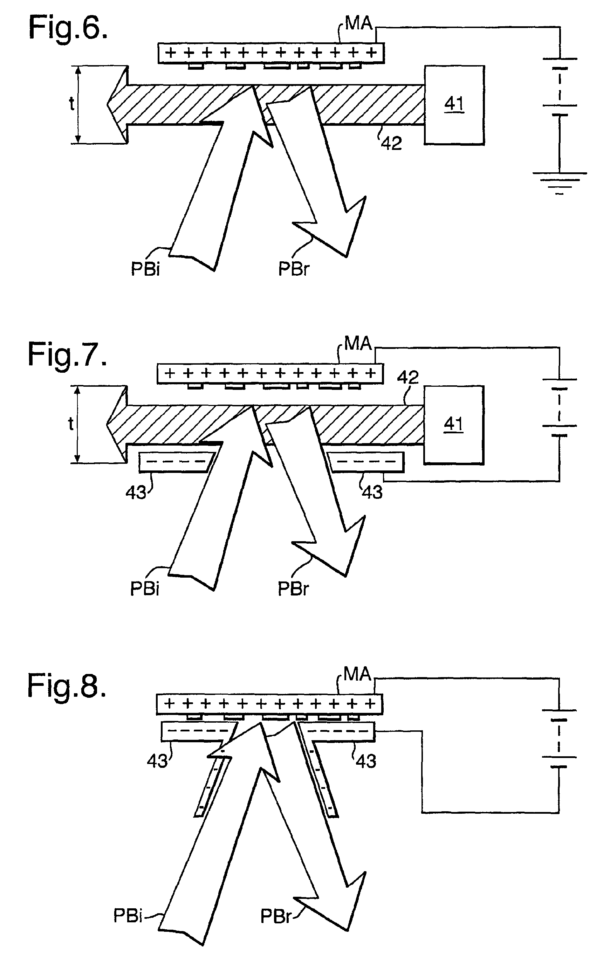

Figure 6 shows ionizing radiation source 41, which directs a transverse beam 42 of ionizing radiation across the region in front of the element to be protected, in this case mask MA. The beam 42 has a thickness, t, perpendicular to the functional surface of the mask MA which is sufficiently large to ensure ionization, preferably multiple ionization, of most or all atoms approaching the mask MA. The wavelength of the radiation should be short (energetic) enough to ensure ionization of all atoms expected, and thus should preferably be shorter than 200nm (6.2eV). For example, an He discharge lamp emitting 59nm radiation (21eV) is suitable. Such sources are generally pulsed and in that case should have a repetition rate fast enough to irradiate all atoms passing through the protective region. For example, a repetition rate of 4kHz may be used with a beam width of 100mm. A gas molecule moving at 400ms$^{-1}$, a typical speed at room temperature, will traverse the shield in a minimum of 0.25ms and thus will be illuminated by at least one pulse.

Embodiment 3

The third embodiment, shown in Figure 7, is a variant of the fourth apparatus. In the third embodiment, collector plates 43, which are negatively charged relative to the mask MA, are added to increase the shielding effect. The collector plates 43 are situated on the other side of the protective beam 42 than the mask MA and serve to attract the positively charged ions repelled by the relatively positive mask MA.

Embodiment 4

The fourth embodiment shown in Figure 8, is a variant of the third embodiment but relies on the projection beam PB to ionize any contaminants approaching the mask MA. In this embodiment the collector shield 43 can be positioned closer to the mask and the path of the projection beam PB.

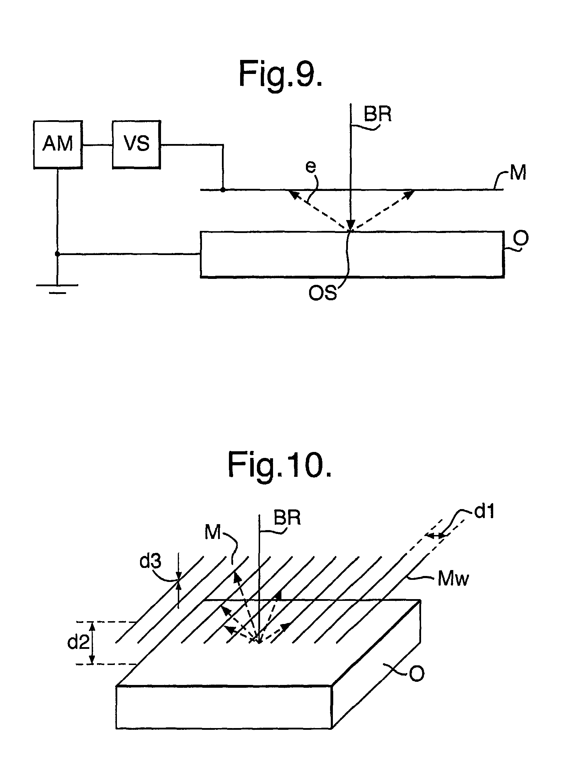

In a fifth apparatus shown in figures 9-12, described for reference and not forming part of the invention, which may be the same as the previous embodiments and apparatus save as described below, a mesh (or grid) is provided at some distance from an object to be shielded so as to attract electrons that are freed from the object due to radiation incident on it.

Figure 9 shows a cross section of object O on the surface OS of which a beam of radiation BR is incident. The object O may be a substrate W, a patterning means such as mask MA, or a mirror within the radiation system IL or the projection system PL. The beam of radiation BR causes electrons *e* to be liberated from the surface OS of the object O. Mesh M is located substantially parallel to and at some distance from the surface OS of the object O. Voltage source VS is connected to the mesh M and applies a predetermined positive voltage to the mesh. Object O is electrically connected to ground potential. As a result the liberated electrons e are attracted to and collected by the mesh M. Object O may also be negatively biased to repel electrons.

Figure 10 shows the mesh M in perspective. In this case, the mesh is comprised of a plurality of parallel wires Mw. The thickness d3 of each of the wires is substantially smaller than the distance d1 between adjacent wires. This ensures that the mesh does not obscure the beam of radiation. Furthermore, the distance d1 between adjacent wires is smaller than the distance d2 of the wires from the surface 1a of the object O. This ensures that the electrical field from the wires to the surface is approximately uniform.

A suitable size range for the wires Mw is a thickness d3 of 2 $\mu$m to 10 $\mu$m. The wires are typically formed from a conductor such as tungsten, molybdenum, copper or zirconium. A particular advantage of zirconium is that it is relatively transparent to EUV. The distance d1 between the wires and the distance d2 of the wires from the surface OS are both typically of the order of 1 cm.

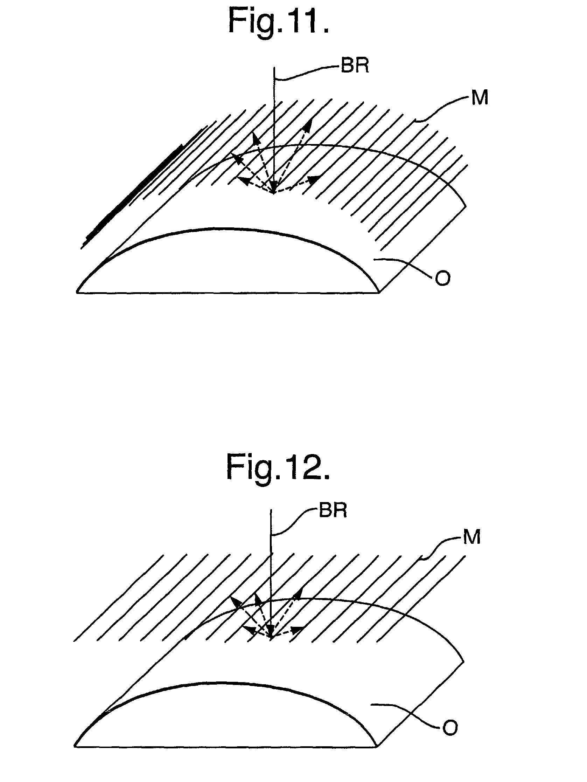

Figures 11 and 12 show the mesh in use with a curved object O. In Figure 11, the mesh M is curved such that it approximately follows the curve of the object O. In Figure 12, the mesh M is substantially planar. Although it is possible for the mesh to follow the curvature of the object O, it is not necessary. In some situations, it may not be possible to position the wires of the mesh to form a curve.

Whilst in the above description the mesh has been described as being comprised of a plurality of parallel wires, it will be appreciated that a variety of patterns may be used advantageously. In particular, there may be situations in which anchoring points for the wires of the mesh are limited, necessitating a different pattern.

Mesh M according to the fifth apparatus described for reference and not forming part of the invention, may advantageously be employed in combination with any one of the previous or subsequent embodiments. In such a case, the electrical field in between a mask MA and mesh M will prevent freed electrons from falling back onto the mask and have them collected by the mesh. Positively charged particles (for instance, particles ionized by ionizing radiation) approaching the mask MA will be repelled or slowed down by the positive bias of the mesh and become deflected as described for the previous embodiments or as will be described further below. Mesh M will be positioned in between mask MA and any of the above elements 11, 12, 21, 31 and 33. The electromagnetic shield will therefore be made up of several adjacent shielding electromagnetic (or purely electric) fields.

Figure 9 further shows a sensing means AM to measure an electrical current induced by the collected electrons.

The electrons freed by the photoelectric effect due to incident radiation from the projection beam and subsequently collected by the mesh M may be used as a measure for the intensity or dose of radiation or as a contamination monitor for the surface of object O.

Embodiment 5

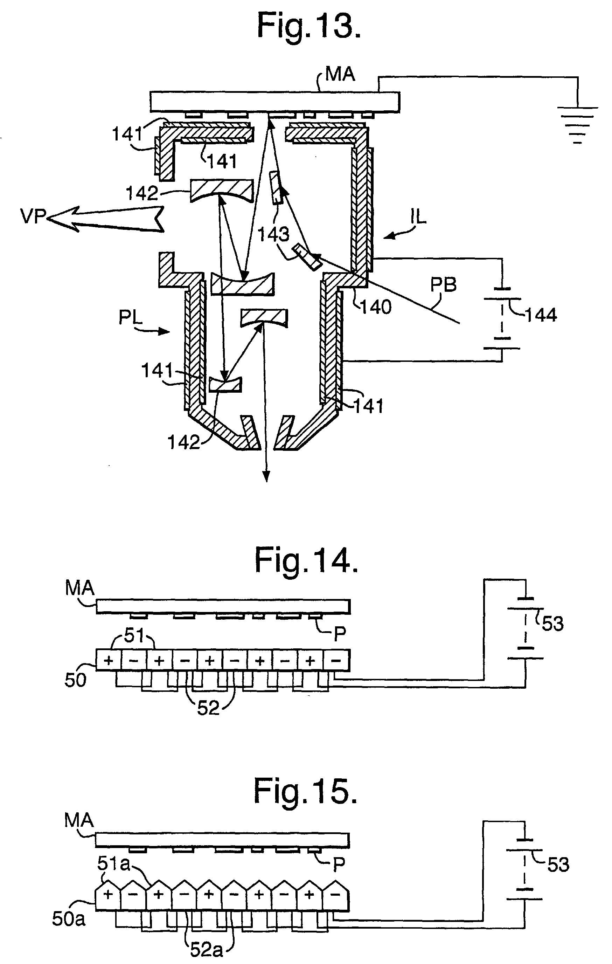

Figure 13 shows part of the illumination system IL, the mask MA and the projection system PL of a lithographic apparatus according to an fifth embodiment of the present invention, which is the same as the first embodiment save as described below.

In the fifth embodiment, a mirror box 140 partially encloses mirrors 142 forming the projection system PL and mirrors 143 forming at least part of the illumination system IL. The mirror box 140 may also be referred to as the projection optics box. According to the invention, the mirror box 140 is provided with electrodes 141 on most of its surfaces, internal and external. The electrodes 141 may be formed as conductive coatings on the surfaces of the mirror box 140. In use of the apparatus, the electrodes 141 are connected to a power supply 144 (e.g. 5 Volts) so that they become charged negatively. The mask MA and any other object (mirrors) to be shielded or some further electrodes are preferably earthed or connected to such an electrical potential as to generate a shielding electric field.

When the apparatus is in use, the mirror box 140 and the mirrors or other optical elements enclosed within it will be under vacuum (in some cases the mirror box 140 may form part of the vacuum chamber wall) and the charged electrodes 141 serve to attract particulates remaining in the vacuum system. Once the particulates have been attracted to and collide with the electrodes 141 they will tend to stick thereto and thus the amount of particulate contamination of the vacuum is reduced.

Preferably, as much free surface area as possible is provided with electrodes to maximize capturing of particulates in the vacuum. As well as the mirror box 140, capture electrodes can be provided on any suitable surface of the vacuum system, for example the rear surfaces of mirrors and other reflective optical elements. A preferable minimum is to provide all suitable surfaces facing and close to the mask with conductive electrodes. In the event that the mirror box 140 is conductive and any sensitive components attached to it can be insulated, it would be possible to charge the mirror box 140 itself to form the particle trap electrodes.

Figure 13 further shows an arrow indicating a flow of gas towards a vacuum pump VP for evacuating the mirror box 140.

Embodiment 6

A sixth embodiment of the invention is a lithographic apparatus such as described with relation to the first embodiment or a mask storage box with a particle shield or trap which is shown in Figure 14.

The particle shield 50 of the sixth embodiment comprises a one- or two-dimensional grid or array of electrodes, 51, 52 which is disposed in proximity to the pattern side P of the mask MA. When the particle shield 50 is used in a mask handling apparatus or mask storage box it can cover the entire surface area of the pattern P. In a lithographic apparatus, the particle shield is either moved out of the way for exposures or provided with a slit corresponding to the illuminated area. To prevent small particles reaching the pattern side of the mask MA, adjacent ones of the electrodes 51, 52 are charged to opposite polarities by power source 53. This establishes electrostatic fields between the adjacent electrodes, which attract positive and negatively charged particles to the oppositely charged electrodes. It should be noted that the electrodes need not be continuously connected to the power supply. If they are well insulated and kept in a vacuum, sufficient charge may be retained by the electrodes to protect the mask MA for a period of time after the power supply has been disconnected.

Figure 15 shows a modified particle shield according to the sixth embodiment. In the particle shield 50a the electrodes 51a, 52a are provided with peaks or ridges so as to enhance field gradients in their vicinity and improve the particle trapping effect.

Embodiment 7

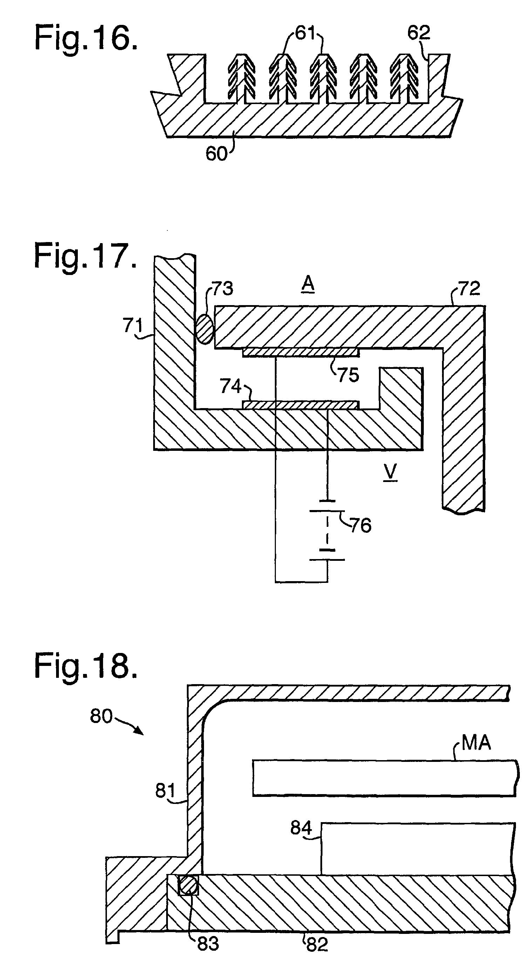

The seventh embodiment is a lithographic projection apparatus or a mask storage box with physical particle traps. These are shown in Figure 16.

The physical particle trap is formed in a recess 62 in a surface of a protective plate 60. Within the recess 62 a plurality of projections 61 are provided. The projections 61 have barbs, in a tree like structure, so that particles entering the recess are hindered by the barbs from escaping and will tend to be captured. The capturing effect is enhanced by charging the projections 61 (as described in embodiment 6) and/or the base of the recess 62. Preferably, the plate 62 is maintained cold so that particles colliding with it will tend to lose kinetic energy, further enhancing the trapping effect. The recess 62 and projections 61 should be made small and can be manufactured using etching techniques.

In a sixth apparatus, which is not illustrated, described for reference and not forming part of the invention particles are prevented from colliding with and sticking to the mask MA in a lithographic apparatus, a mask handling apparatus or a mask storage box by providing a temperature difference between the mask and its surroundings.

The temperature difference can be provided by providing a heater, e.g. a lamp, to heat the mask and/or by providing a cold plate, cooled by a suitable cooler, in the vicinity of the pattern surface of the mask MA. The presence of a cold surface near the mask reduces particle adherence to the mask because particles colliding with the cold surface will tend to lose kinetic energy and hence are more likely to stick to the cold surface. Heating the mask to a temperature higher than its surrounding causes a continuous thermophoretic effect.

A seventh apparatus described for reference and not forming part of the invention provides a vacuum seal shown in Figure 17, which may be used in a vacuum chamber of a lithographic apparatus or a mask handling apparatus.

In the seventh apparatus described for reference and not forming part of the invention two wall parts 71, 72 partially overlap and are sealed together by a mechanical seal 73. The walls 71, 72 separate a vacuum chamber V from ambient pressure A. On the vacuum side of the mechanical seal 73, two electrodes 74, 75 are provided, one on wall part 71 and one on wall part 72. The electrodes 74, 75 are connected to power supply 76 so as to be charged to opposite polarities. These electrodes then serve to trap any charged particles that may be generated by mechanical seal 73. Further, any one of the solutions of embodiments 10 and 11 may be provided near seal 73 on the vacuum side to trap particles from seal 73.

Embodiment 8

An eighth embodiment of the invention provides a mask storage box in which mask may be stored for extended periods of time.

A mask storage box 80, shown in part in Figure 18, comprises a main housing 81 and a housing bottom 82 which form an enclosed chamber in which mask MA may be stored. The mask MA is held in place by appropriate clamping means (not shown). The enclosed chamber may be under vacuum or filled with a contaminant-free inert gas. In ether case, the housing is closed by seal 83. Where the enclosed chamber is under vacuum, the seal 83 may incorporate electrodes to trap particles as described in the ninth embodiment.

Also within the enclosed chamber, a particle shield device 84 is provided. The particle shield device 84 serves to trap particles that may be present in the enclosed chamber or otherwise prevent them reaching the mask MA, particularly the patterned surface thereof, and may be constructed as described above in relation to any or the first to seventh embodiments. A power source is included in the mask storage box 80. The particle shield may be arranged to be powered from an external source during long-term storage but is also provided with a, preferably rechargeable, internal power source to maintain the particle shield 84 operational during transportation.

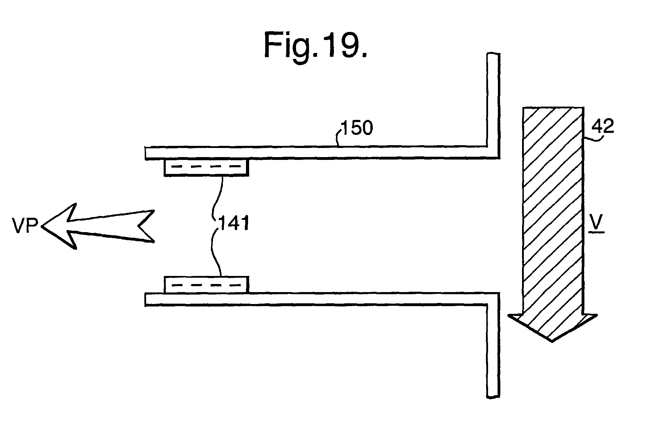

Figure 19 shows an eighth apparatus described for reference and not forming part of the invention. It shows a tube 150 in which an electric field is generated by electrodes 141. Tube 150 may be connected to a vacuum pump VP for evacuating a vacuum chamber V to which the other end of tube 150 is connected. Negatively-charged electrodes are arranged at the inside of tube 150 to transport particles out of chamber V is which one or more objects to be shielded are located. The tube may be located at the left-hand side of the mirror box 140 shown in figure 13. However, it may also be connected to some mask-handling apparatus, for instance, one in which a mask is cleaned before use in a projection apparatus. Particles released from the patterned surface of the mask may then be extracted by electric fields through a tube 150. An ionizing beam 42 of radiation may optionally be employed. Any configuration of electrodes extracted particles out of space V, for instance, as discussed for previous embodiments, is appropriate and is not limited to the one shown in Figure 19.

Whilst we have described above specific embodiments of the invention it will be appreciated that the invention may be practiced otherwise than described. The description is not intended to limit the invention which is defined by the claims. In particular, it will be appreciated that the particle shields of the different embodiments may be combined so that a particle shield according to the invention may make use of any one or more of: a uniform electric field, a non-uniform electric field, an optical breeze, ionizing radiation and charging of the object to be shielded. The invention can be used in lithography apparatus using a projection beam of electro-magnetic radiation, especially but not exclusively having a wavelength less than about 200nm, for instance, 193nm, 157nm or EUV radiation (e.g. having a wavelength in the range of 8 to 20nm, especially 9 to 16nm).

**Claims**

1.   A lithographic projection apparatus comprising:

   a radiation system (IL) for supplying a projection beam (PB) of electro-magnetic radiation;

a mask table (MT) for supporting a mask (MA), the mask serving to pattern the projection beam according to a devised pattern;

a substrate table (WT) for holding a substrate (W); and

a projection system (PL) for projecting the patterned beam onto a target portion (C) of the substrate (W); particle shield means (10; 20; 43; 141; 144; 50; 50a) arranged to generate an electric field so as to prevent particles to become incident on a mask (MA), supported by said mask table (MT), **characterised in that** said particle shield means (10;20;43;141;144;50;50a) is adapted to generate said electric field in the vicinity of said mask (MA) supported by said mask table (MT) and comprises an electrode (12; 21; 43; 141; 52; 52a) and means arranged to negatively charge said electrode (12;21;43;141;52;52a) relative to said mask (MA) supported by said mask table (MT).

2. An apparatus according to Claim 1, wherein said particle shield means is configured and arranged so as to deflect particles approaching the mask (MA) supported by said mask table (MT).

3. Apparatus according to any one of the preceding Claims, wherein said particle shield means (10; 20; 43; 141; 144; 50; 50a) is adapted to generate a non-uniform electric field.

4. Apparatus according to Claim 3, wherein said particle shield means (10; 20; 43; 141; 144; 50; 50a) comprises an elongate charged member.

5. Apparatus according to any one of the preceding Claims, wherein said particle shield means (10; 20; 43; 141; 144; 50; 50a) is adapted to generate a substantially uniform electric field.

6. Apparatus according to Claim 5, wherein said particle shield means comprises a pair of conductive plates (11,12) arranged substantially parallel to each other on either side of a region adjacent said mask (MA) supported by said mask table (MT) and means for establishing a potential difference between said pair of conductive plates (11,12).

7. Apparatus according to any one of the preceding Claims, wherein said particle shield means (10;20;43;141;144;50; 50a) comprises a grid (M) or array of electrodes (51, 52; 51a,52a).

8. Apparatus according to Claim 7, wherein said grid (M) or array of electrodes (51,52;51a,52a) is arranged substantially parallel to a surface to be shielded of said mask (MA) supported by said mask table (MT).

9. Apparatus according to any one of the preceding Claims, wherein said particle shield means (10;20;43;141;144;50; 50a) comprises an electrostatic getterer plate and means for charging said electrostatic getterer plate to a potential so as to generate an electric field to attract particles.

10. Apparatus according to any one of the preceding Claims, wherein said particle shield means (10;20;43;141;144;50; 50a) are configured and arranged to transport particles out of a space within said apparatus.

11. Apparatus according to any one of the preceding Claims, wherein said particle shield means (10;20;43;141;144;50; 50a) further comprises a radiation source (41) arranged to generate a beam of radiation (42).

12. Apparatus according to Claim 11, wherein said radiation source (41) is adapted to generate an electromagnetic beam (42) effective as an optical breeze to deflect particles by momentum transfer.

13. Apparatus according to Claim 11 or 12, wherein said radiation source (41) is adapted to generate a beam of radiation (42) capable of ionizing particles.

14. Apparatus according to any one of the preceding Claims, wherein said particle shield means (10;20;43;141;144;50; 50a) comprises means for charging said mask (MA) supported by said mask table (MT) to a bias potential relative to its surroundings.

15. Apparatus according to any one of the preceding claims, further comprising a mask handling part for transferring said mask (MA) to said mask table (MT), and wherein said mask handling part comprises said particle shield means (10;20;43;141;144;50;50a) for shielding said mask (MA).

16. A device manufacturing method comprising the steps of:

providing a substrate (W) which is at least partially covered by a layer of radiation sensitive material to a substrate table (WT);

providing a projection beam (PB) of electro-magnetic radiation using a radiation system (IL);

using a mask (MA) to endow the projection beam with a pattern in its cross section; and

projecting the patterned beam of radiation with a projection system (PL) onto a target portion (C) of the layer of radiation sensitive material; **characterised by**:

generating an electric field in the vicinity of said mask (MA) so as to prevent particles to become incident on said mask (MA) by charging an electrode (12;21;43;141;52;52a) negatively relative to said mask (MA).

**17.** A transportable mask storage box (80) comprising:

a chamber (81, 82) for enclosing a mask (MA) during handling, transportation or storage thereof; and

a particle shield (84) for preventing or reducing the contamination of at least the patterned surface of said mask (MA) by particles;

said particle shield (84) comprising an electrode and means arranged to generate an electric field so as to prevent particles becoming incident on at least the patterned surface of said mask (MA) **characterized in that** a power source included in the transportable mask storage box (80) is arranged to power said particle shield (84).

**18.** A transportable mask storage box according to Claim 17, wherein said particle shield (84) comprises a grid or array of electrodes.

**19.** A transportable mask storage box according to Claims 17 or 18, wherein said particle shield (84) further comprises a heater for maintaining said mask (MA) at a temperature greater than its surroundings.

**20.** A transportable mask storage box according to Claim 17, 18 or 19, wherein said particle shield further comprises a plate disposed proximate said mask (MA) and a cooler for maintaining said plate at a temperature less than the temperature of said mask (MA).

**Patentansprüche**

**1.** Lithographischer Projektionsapparat, mit:

einem Strahlungssystem (IL) für die Zufuhr eines Projektionsstrahls (PB) aus elektromagnetischer Strahlung;

einem Maskentisch (MT) zum Abstützen einer Maske (MA), wobei die Maske dazu dient, den Projektionsstrahl gemäß einem erdachten Muster mit einem Muster zu versehen;

einem Substrattisch (WT) zum Halten eines Substrats (W); und

einem Projektionssystem (PL) zum Projizieren des mit einem Muster versehenen Strahls auf einen Zielabschnitt (C) des Substrats (W);

einer Teilchenabschirmeinrichtung (10; 20; 43; 141; 144; 50; 50a), die angeordnet ist, um ein elektrisches Feld zu erzeugen, um zu verhindern, dass Teilchen auf eine Maske (MA), die durch den Maskentisch (MT) gestützt wird, auftreffen,

**dadurch gekennzeichnet, dass** die Teilchenabschirmeinrichtung (10; 20; 43; 141; 144; 50; 50a) angepasst ist, um das elektrische Feld in der Nähe der Maske (MA), die durch den Maskentisch (MT) gestützt wird, zu erzeugen und eine Elektrode (12; 21; 43; 141; 52; 52a) und Einrichtungen umfassen, welche die Elektrode (12; 21; 43; 141; 52; 52a) in Bezug auf die Maske (MA), die durch den Maskentisch (MT) gestützt wird, negativ laden.

**2.** Apparat nach Anspruch 1, wobei die besagte Teilchenabschirmeinrichtung so ausgebildet und angeordnet ist, dass sie Teilchen ablenkt, die sich der Maske (MA), welche durch den Maskentisch (MT) gestützt wird, nähern.

**3.** Apparat nach einem der vorhergehenden Ansprüche, wobei die Teilchenabschirmeinrichtung (10; 20; 43; 141; 144; 50; 50a) angepasst ist, um ein uneinheitliches elektrisches Feld zu bilden.

**4.** Apparat nach Anspruch 3, wobei die Teilchenabschirmeinrichtung (10; 20; 43; 141; 144; 50; 50a) ein längliches geladenes Element umfasst.

**5.** Apparat nach einem der vorhergehenden Ansprüche, wobei die Teilchenabschirmeinrichtung (10; 20; 43; 141; 144;

50; 50a) angepasst ist, um ein im wesentlichen einheitliches elektrisches Feld zu erzeugen.

6. Apparat nach Anspruch 5, wobei die Teilchenabschirmeinrichtung zwei leitende Platten (11, 12) umfasst, die im wesentlichen parallel zueinander an jeder Seite eines Bereichs neben der Maske (MA), die vom Maskentisch (MT) getragen wird, sind, sowie Einrichtungen zum Erstellen einer Potentialdifferenz zwischen den beiden leitenden Platten (11, 12).

7. Apparat nach einem der vorhergehenden Ansprüche, wobei die Teilchenabschirmeinrichtung (10; 20; 43; 141; 144; 50; 50a) ein Gitter (M) oder ein Feld von Elektroden (51, 52; 51a, 52a) umfasst.

8. Apparat nach Anspruch 7, wobei das Gitter (M) oder das Feld von Elektroden (51, 52; 51a, 52a) im wesentlichen parallel zu einer abzuschirmenden Oberfläche der Maske (MA), die von dem Maskentisch (MT) gestützt wird, angeordnet ist.

9. Apparat nach einem der vorhergehenden Ansprüche, wobei die Teilchenabschirmeinrichtung (10; 20; 43; 141; 144; 50; 50a) eine elektrostatische Getterplatte und Einrichtungen zum Laden der elektrostatischen Getterplatte auf ein Potential umfasst, um ein elektrisches Feld zum Anziehen von Teilchen zu erzeugen.

10. Apparat nach einem der vorhergehenden Ansprüche, wobei die Teilchenabschirmeinrichtungen (10; 20; 43; 141; 144; 50; 50a) ausgebildet und angeordnet sind, um Teilchen aus einem Raum innerhalb des Apparates herauszutransportieren.

11. Apparat nach einem der vorhergehenden Ansprüche, wobei die Teilchenabschirmeinrichtung (10; 20; 43; 141; 144; 50; 50a) ferner eine Strahlungsquelle (41) umfasst, die angeordnet ist, um einen Strahl aus Strahlung (42) zu erzeugen.

12. Apparat nach Anspruch 11, wobei die Strahlungsquelle (41) angepasst ist, um einen elektromagnetischen Strahl (42) zu erzeugen, der als optische Brise wirkt, um Teilchen durch Impulsübertragung abzulenken.

13. Apparat nach Anspruch 11 oder 12, wobei die Strahlungsquelle (41) angepasst ist, um einen Strahlungsstrahl (42) zu erzeugen, der in der Lage ist, Teilchen zu ionisieren.

14. Apparat nach einem der vorhergehenden Ansprüche, wobei die Teilchenabschirmeinrichtung (10; 20; 43; 141; 144; 50; 50a) Einrichtungen zum Laden der Maske (MA), die von dem Maskentisch (MT) gestützt wird, auf eine Vorspannung relativ zu ihrer Umgebung umfasst.

15. Apparat nach einem der vorhergehenden Ansprüche, ferner mit einem Element zur Handhabung von Masken zum Weiterleiten der Maske (MA) zum Maskentisch (MT) und wobei das Element zur Handhabung von Masken die Teilchenabschirmeinrichtung (10; 20; 43; 141; 144; 50; 50a) zum Abschirmen der Maske (MA) umfasst.

16. Verfahren zur Herstellung eines Bauteils, das folgende Schritte umfasst:

Bereitstellen eines Substrats (W), das zumindest teilweise von einer Schicht aus strahlungsempfindlichem Material bedeckt ist, auf einem Substrattisch (WT);
Bereitstellen eines Projektionsstrahls (PB) aus elektromagnetischer Strahlung unter Verwendung eines Strahlungssystems (IL);
Verwenden einer Maske (MA), um dem Projektionsstrahl in seinem Querschnitt ein Muster aufzuprägen; und
Projizieren des mit einem Muster versehenen Strahls aus Strahlung mit Hilfe eines Projektionssystems (PL) auf einen Zielabschnitt (C) der Schicht aus strahlungsempfindlichem Material;

**gekennzeichnet durch**:

Erzeugen eines elektrischen Feldes in der Nähe der Maske (MA), um zu verhindern, dass Teilchen auf die Maske (MA) auftreffen, indem eine Elektrode (12; 21; 43; 141; 52; 52a) negativ in Bezug auf die Maske (MA) geladen wird.

17. Transportables Gehäuse (80) zum Aufbewahren von Masken, mit:

einer Kammer (81, 82) zur Aufnahme einer Maske (MA), während diese benutzt, transportiert oder aufbewahrt wird; und

einer Teilchenabschirmung (84) zur Vermeidung oder Verminderung der Verunreinigung von wenigstens der mit einem Muster versehenen Oberfläche der Maske (MA) durch Teilchen; wobei die Teilchenabschirmung (84) eine Elektrode und Einrichtungen umfasst, die angeordnet sind, um ein elektrisches Feld zu erzeugen, um zu verhindern, dass Teilchen auf zumindest die mit einem Muster versehene Oberfläche der Maske (MA) auftreffen, **dadurch gekennzeichnet, dass** eine in dem transportablen Gehäuse (80) zum Aufbewahren von Masken enthaltene Stromquelle angeordnet ist, um die Teilchenabschirmung (84) mit Strom zu versorgen.

18. Transportables Gehäuse (80) zum Aufbewahren von Masken nach Anspruch 17, wobei die Teilchenabschirmung (84) ein Gitter oder Feld von Elektroden umfasst.

19. Transportables Gehäuse (80) zum Aufbewahren von Masken nach den Ansprüchen 17 oder 18, wobei die Teilchenabschirmung (84) ferner eine Heizeinrichtung umfasst, um die Maske (MA) auf einer Temperatur zu halten, die über der Temperatur ihrer Umgebung liegt.

20. Transportables Gehäuse (80) zum Aufbewahren von Masken nach Anspruch 17, 18 oder 19, wobei die Teilchenabschirmung ferner eine Platte umfasst, die in der Nähe der Maske (MA) angeordnet ist, und eine Kühleinrichtung, um die Platte auf einer Temperatur zu halten, die unter der Temperatur der Maske (MA) liegt.

## Revendications

1. Appareil de projection lithographique comprenant :

un système de rayonnement (IL) pour délivrer un faisceau de projection (PB) de rayonnement électromagnétique ;
une table de masque (MT) pour supporter un masque (MA), le masque servant à modeler le faisceau de projection conformément à un motif conçu ;
une table de substrat (WT) pour maintenir un substrat (W) ; et
un système de projection (PL) pour projeter le faisceau modelé sur une partie cible (C) du substrat (w) ;
des moyens de protection anti-particules (10 ; 20 ; 43 ; 141 ; 144 ; 50 ; 50a) conçus pour générer un champ électrique de manière à empêcher des particules de venir frapper un masque (MA) supporté par ladite table de masque (MT),

**caractérisé en ce que** lesdits moyens de protection anti-particules (10 ; 20 ; 43 ; 141 ; 144 ; 50 ; 50a) sont adaptés pour générer ledit champ électrique à proximité dudit masque (MA) supporté par ladite table de masque (MT) et comportent une électrode (12 ; 21 ; 43 ; 141 ; 52 ; 52a) et des moyens conçus pour charger négativement ladite électrode (12 ; 21 ; 43 ; 141 ; 52 ; 52a) par rapport audit masque (MA) supporté par ladite table de masque (MT).

2. Appareil selon la revendication 1, dans lequel lesdits moyens de protection anti-particules sont configurés et conçus de manière à dévier des particules se rapprochant du masque (MA) supporté par ladite table de masque (MT).

3. Appareil selon l'une quelconque des revendications précédentes, dans lequel lesdits moyens de protection anti-particules (10 ; 20 ; 43 ; 141 ; 144 ; 50 ; 50a) sont adaptés pour générer un champ électrique non-uniforme.

4. Appareil selon la revendication 3, dans lequel lesdits moyens de protection anti-particules (10 ; 20 ; 43 ; 141 ; 144 ; 50 ; 50a) comportent un élément chargé allongé.

5. Appareil selon l'une quelconque des revendications précédentes, dans lequel lesdits moyens de protection anti-particules (10 ; 20 ; 43 ; 141 ; 144 ; 50 ; 50a) sont adaptés pour générer un champ électrique sensiblement uniforme.

6. Appareil selon la revendication 5, dans lequel lesdits moyens de protection anti-particules comportent une paire de plaques conductrices (11, 12) agencées sensiblement parallèlement l'une à l'autre sur chaque côté d'une région adjacente audit masque (MA) supporté par ladite table de masque (MT) et des moyens pour établir une différence de potentiel entre ladite paire de plaques conductrices (11, 12).

7. Appareil selon l'une quelconque des revendications précédentes, dans lequel lesdits moyens de protection anti-particules (10 ; 20 ; 43 ; 141 ; 144 ; 50 ; 50a) comportent une grille (M) ou une matrice d'électrodes (51, 52 ; 51a, 52a).

**8.** Appareil selon la revendication 7, dans lequel ladite grille (M) ou matrice d'électrodes (51, 52 ; 51a, 52a) est agencée sensiblement parallèlement à une surface pour être protégée dudit masque (MA) supporté par ladite table de masque (MT).

**9.** Appareil selon l'une quelconque des revendications précédentes, dans lequel lesdits moyens de protection anti-particules (10 ; 20 ; 43 ; 141 ; 144 ; 50 ; 50a) comportent une plaque de getter électrostatique et des moyens pour charger ladite plaque de getter électrostatique à un potentiel de manière à générer un champ électrique pour attirer des particules.

**10.** Appareil selon l'une quelconque des revendications précédentes, dans lequel lesdits moyens de protection anti-particules (10 ; 20 ; 43 ; 141 ; 144 ; 50 ; 50a) sont configurés et conçus pour transporter des particules en dehors d'un espace dans ledit appareil.

**11.** Appareil selon l'une quelconque des revendications précédentes, dans lequel lesdits moyens de protection anti-particules (10 ; 20 ; 43 ; 141 ; 144 ; 50 ; 50a) comportent de plus une source de rayonnement (41) conçue pour générer un faisceau de rayonnement (42).

**12.** Appareil selon la revendication 11, dans lequel ladite source de rayonnement (41) est adaptée pour générer un faisceau électromagnétique (42) efficace en tant que brise optique pour dévier des particules par un transfert de mouvement.

**13.** Appareil selon la revendication 11 ou 12, dans lequel ladite source de rayonnement (41) est adaptée pour générer un faisceau de rayonnement (42) capable d'ioniser des particules.

**14.** Appareil selon l'une quelconque des revendications précédentes, dans lequel lesdits moyens de protection anti-particules (10 ; 20 ; 43 ; 141 ; 144 ; 50 ; 50a) comprennent des moyens pour charger ledit masque (MA) supporté par ladite table de masque (MT) à un potentiel de polarisation par rapport à son environnement.

**15.** Appareil selon l'une quelconque des revendications précédentes, comprenant de plus une partie de manipulation de masque pour transférer ledit masque (MA) vers ladite table de masque (MT), et dans lequel ladite partie de manipulation de masque comprend lesdits moyens de protection anti-particules (10 ; 20 ; 43 ; 141 ; 144 ; 50 ; 50a) pour protéger ledit masque (MA).

**16.** Procédé de fabrication d'un dispositif, comprenant les étapes consistant à :

fournir un substrat (W) qui est au moins partiellement recouvert d'une couche de matériau sensible au rayonnement sur une table de substrat (WT) ;
fournir un faisceau de projection (PB) de rayonnement électromagnétique en utilisant un système de rayonnement (IL) ;
utiliser un masque (MA) pour soumettre le faisceau de projection à un motif suivant sa coupe transversale ; et projeter le faisceau de rayonnement modelé à l'aide d'un système de projection (PL) sur une partie cible (C) de la couche de matériau sensible au rayonnement ; **caractérisé par** :

la génération d'un champ électrique à proximité dudit masque (MA) de manière à empêcher des particules de venir frapper ledit masque (MA) en chargeant une électrode (12 ; 21 ; 43 ; 141 ; 52 ; 52a) négativement par rapport audit masque (MA).

**17.** Boîtier de stockage de masque transportable (80), comprenant :

une chambre (81, 82) pour enfermer un masque (MA) durant une manipulation, un transport ou un stockage de celui-ci ; et
une protection anti-particules (84) pour empêcher ou réduire la contamination d'au moins la surface modelée dudit masque (MA) par des particules ;
ladite protection anti-particules (84) comportant une électrode et des moyens conçus pour générer un champ électrique de manière à empêcher des particules de venir frapper au moins la surface modelée dudit masque (MA), **caractérisé en ce qu'**une source de puissance incluse dans le boîtier de stockage de masque transportable (80) est conçue pour alimenter ladite protection anti-particules (84).

**18.** Boîtier de stockage de masque transportable selon la revendication 17, dans lequel ladite protection anti-particules (84) comprend une grille ou une matrice d'électrodes.

**19.** Boîtier de stockage de masque transportable selon la revendication 17 ou 18, dans lequel ladite protection anti-particules (84) comprend de plus un dispositif de chauffage pour maintenir ledit masque (MA) à une température supérieure à son environnement.

**20.** Boîtier de stockage de masque transportable selon la revendication 17, 18 ou 19, dans lequel ladite protection anti-particules comprend de plus une plaque disposée à proximité dudit masque (MA) et un dispositif de refroidissement pour maintenir ladite plaque à une température inférieure à la température dudit masque (MA).

# Fig.1.

# Fig.2.

## Fig.3.

## Fig.4.

## Fig.5.

Fig.6.

Fig.7.

Fig.8.

# Fig.9.

# Fig.10.

# Fig.11.

# Fig.12.

# Fig.13.

MA

141

141

142

VP

143

IL

PL

140

PB

144

141

142

141

# Fig.14.

MA

P

53

51

+ − + − + − + − + −

50

52

# Fig.15.

MA

P

51a

53

+ − + − + − + − + −

50a

52a

## Fig.16.

## Fig.17.

## Fig.18.

# Fig.19.